# EUROPEAN PATENT APPLICATION

(11) **EP 3 035 391 A1**
(43) Date of publication of application: **22.06.2016**
(21) Application number: 13891455.1
(22) Date of filing: 16.08.2013
(51) Int. Cl.: H01L 31/00

(54) **PHOTOELECTRIC CONVERSION EYELET FABRIC AND SUN SHED**

(71) Applicant: Shenzhen Zhitan Organic Farming Energy Comprehensi, Shenzhen, Guangdong 518104 (CN)
(72) Inventor: GONG, Shugang, Shenzhen Guangdong 518104 (CN); JIANG, Yong, Shenzhen Guangdong 518104 (CN); HUANG, Tao, Shenzhen Guangdong 518104 (CN); GUO, Zhiling, Shenzhen Guangdong 518104 (CN); GUO, Jianjun, Shenzhen Guangdong 518104 (CN)
(74) Representative: Wright, Howard Hugh Burnby
(86) International application number: PCT/CN2013/081599
(87) International publication number: WO 2015/021642

(57) **Abstract**

A photoelectric conversion eyelet fabric and a sun shed. The photoelectric conversion eyelet fabric (1) comprises a fabric body (15), wherein the fabric body (15) is provided with a plurality of eyelets (12), which penetrate through the fabric body (15) and are arranged at intervals; and one side of the fabric body (15) is provided with a photoelectric conversion element (11) having a waterproof facility and electrically connected to an energy storage battery. The plurality of eyelets are arranged on the fabric body (15) of the eyelet fabric (1), so that the eyelet fabric has a ventilation effect and can weaken strong wind; and the eyelets can partition rainwater falling thereon into water mist, sunlight is converted into electric energy by using the photoelectric conversion element (11), the electric energy is stored in the energy storage battery, and the eyelets (12) refract and reflect light of for multiple times and partition the light entering therein for multiple times, so that the sensitivity of organisms under the eyelet fabric (1) to rainwater and sunlight is reduced, and the eyelet fabric (1) is energy-saving and environment-friendly.

## Description

### THCHNICAL FIELD

The present application relates to the technical field of eyelet fabric, and more particularly, relates to photoelectric conversion eyelet fabric and a sun shed comprising the photoelectric conversion eyelet fabric.

### BACKGROUND

Sun sheds are widely used objects configured for blocking wind and rain and preventing people from sunlight irradiation, for example, a sun shed can cover an outdoor device, or a sun shed can be used to cover a temporary house configured for keeping people from wind and rain, and so on.

In the prior art, the sun shed is usually made from a close-grained fabric body with some additional accessories, in order to get an effect of blocking wind and rain, the fabric body is usually closed completely and close-grained. However, this can only provide a blocking function. When wind and rain are fierce, it is easy to blow away the sun shed, and the effect of blocking wind and rain is hard to be implemented; moreover, the fabric body of the sun shed can't bear any photoelectric conversion element, therefore it is impossible to make use of solar energy.

### TECHNICAL PROBLEM

The present application aims at providing eyelet fabric having a photoelectric conversion function, which is configured for solving the problem in the prior art that a fabric body of a sun shed is easy to be blown away by wind and rain and cannot make use of solar energy.

### TECHNICAL SOLUTION

The present invention is implemented in this way: a photoelectric conversion eyelet fabric including a fabric body, wherein the fabric body is provided therein with a plurality of eyelets which penetrate through the fabric body and are arranged at intervals, one side of the fabric body is provided with a photoelectric conversion element having waterproof facility and electrically connected to an energy storage battery.

Further, metal wires are arranged on the fabric body, the metal wires are grounded in use, deviate from the photoelectric conversion component, and are positioned among the plurality of eyelets.

Further, the photoelectric conversion element is connected to one side of the fabric body via a collodion silk or other physical ways.

Further, the plurality of eyelets are distributed on the fabric body in a plurality of rows to form a plurality of eyelet rows arranged at intervals.

Further, adjacent ones of the eyelet rows are arranged at intervals.

Further, the metal wires are positioned between adjacent ones of the eyelet rows.

The present invention further provides a sun shed which comprises the aforesaid photoelectric conversion eyelet fabric.

### BENEFICIAL EFFECTS

Compared with the prior art, the fabric body of the eyelet fabric is provided therein with a plurality of eyelets, which have ventilation effect and can weaken strong wind. The eyelets is capable of partitioning rainwater, rainwater falling thereon can be partitioned into water mist. Solar power can be converted into electric power by the photoelectric conversion element, and the electric power can be stored in the energy storage battery. The eyelets refract and reflect sunlight for multiple times, and partition sunlight entering the eyelet fabric for multiple times, thereby reducing the sensitivity of organisms under the eyelet fabric to rainwater and sunlight, so that the eyelet fabric is energy-saving and environment-friendly.

### BRIEF DESCRIPTION OF THE DRAWINGS

FIG. 1 illustrates a schematic front view of a photoelectric conversion eyelet fabric provided by one embodiment of the present invention;
FIG. 2 illustrates an enlarged view of the position A in figure 1.

### DETAILED DESCRIPTION OF THE PREFERRED EMBODIMENT

In order to make the purpose, the technical features and the advantages of the present application be more clear, the present application will be described in detail with reference to the accompanying drawings and embodiments. It should be understood that the specific embodiments described herein are used for interpretation of present invention merely, rather than the limitation to the present invention.

The implementation of the present invention is described in detail with reference to specified embodiments in the following.

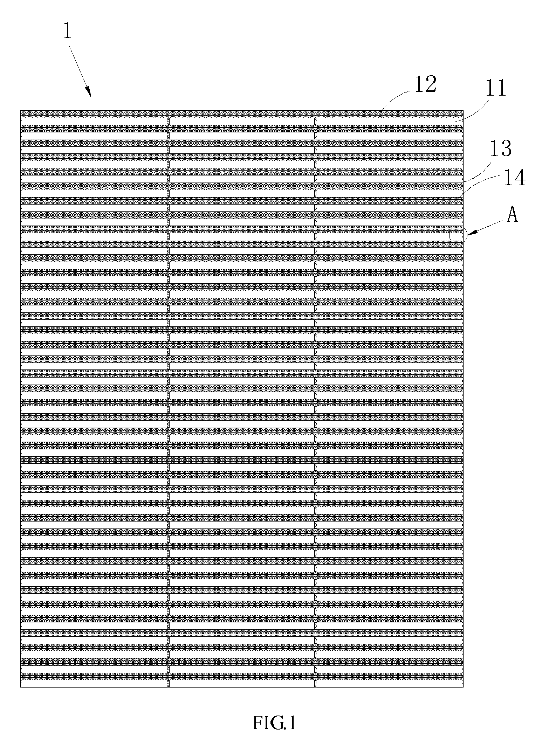

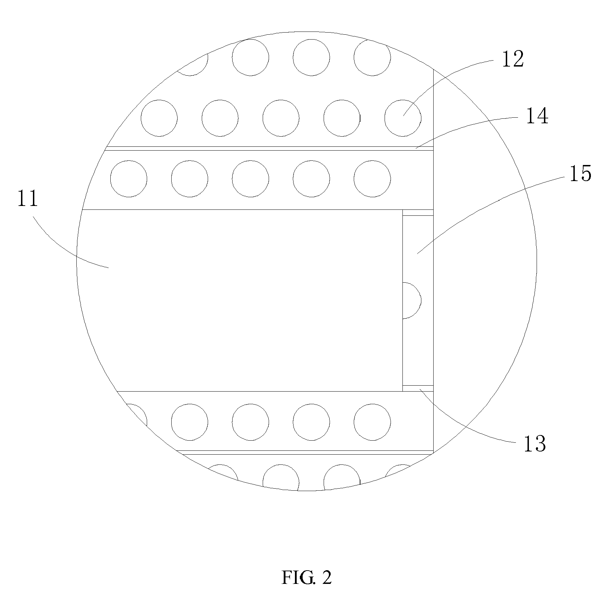

As shown in figure 1 and figure 2, a preferable embodiment is provided by the present invention.

As shown in figure 1 and figure 2, an eyelet fabric 1 provided by the embodiment can be applied in a sun shed, of course, the eyelet fabric 1 can also be applicable in other devices, and the application scope of which should not be restricted by the embodiment of the present invention.

A photoelectric conversion eyelet fabric 1 of the present embodiment comprises a fabric body 15, the fabric body 15 is provided therein with a plurality of eyelets 12, the eyelets 12 are arranged at intervals, and penetrate through an upper end face and a lower end face of the fabric body 15; the upper end face of the fabric body 15 is provided with a plurality of photoelectric conversion elements 11, which have waterproof facilities and are electrically connected to an energy storage battery; the photoelectric conversion elements 11 can transform light irradiated thereon into electric energy and store the electric energy in the energy storage battery.

Of course, when the photoelectric conversion elements 11 are positioned on the upper end face of the fabric body 15, they can shield some of the eyelets 12. The rest of the eyelets 12 which are not shielded by the photoelectric conversion elements 11 are exposed outside. The plurality of photoelectric conversion elements 11 can be arranged in parallel or in series, and the specific arrangement of the plural photoelectric conversion elements 11 can be determined according to actual needs.

In the photoelectric conversion eyelet fabric 1 provided above, since the plurality of eyelets 12 are formed in the fabric body 15, the photoelectric conversion eyelet fabric 1 have a ventilation effect, and can weaken strong wind; the eyelets 12 can partition and guide rainwater, by partitioning rainwater falling on the fabric body 15 using the eyelets 12, rainwater entering the fabric body 15 are made to become mist-shaped, and the sensitivity of organisms under the fabric body 15 to rainwater is reduced; when sunlight shines on the surface of the fabric body 15, the sunlight irradiated directly on the photoelectric conversion elements 11 can be converted into solar energy; in particular, by the photoelectric conversion elements 11, solar energy is converted into electric energy, and the electric energy is stored in the energy storage battery. With respect to sunlight that does not irradiates on the photoelectric conversion elements 11, a part of this sunlight is reflected by the fabric body 15, and another part of this sunlight irradiates into the eyelet fabric 1 through the eyelets 12; in the process of the irradiation, inner walls of the eyelets 12 refract and reflect sunlight therein for multiple times, thereby playing a role of sunlight partitioning and reducing the sensitivity of, for example, the organisms under the eyelet fabric 1 to sunlight.

In this embodiment of the present invention, two ends of a photoelectric conversion element 11 are respectively connected with the upper end face of the fabric body 15 via collodion silks or other physical ways. Of course, other connection ways, such as a stitching connection, can also be applicable; the connection ways should not be limited by the connection ways introduced in this embodiment of the present invention.

The upper end face of the fabric body 15 is provided thereon with metal wires 14, the metal wires 14 are grounded, deviate from the photoelectric conversion element 11, and are arranged among the eyelets 12; that is, the metal wires 14 are arranged out of lateral sides of the photoelectric conversion elements 11, and disposed on parts of the fabric body 15 positioned between the eyelets 12, so that the eyelets 12 will not be blocked. The grounded metal wires 14 are arranged on the fabric body 15, in this way, the photoelectric conversion eyelet fabric 1 can have the effect of preventing from lighting strokes, and so on.

In this embodiment of the present invention, the plurality of eyelets 12 are distributed on the fabric body 15 in rows to form a plurality of eyelet rows arranged at intervals, and a plurality of eyelets 12 in each eyelet row are arranged at intervals. Specifically, eyelets 12 of one eyelet row and eyelets 12 of another adjacent eyelet row can be mal-posed, or alternatively aligned.

The aforesaid metal wires 14 are arranged between every two adjacent eyelet rows, in this way, the metal wires 14 are arranged linearly, and are parallel to the eyelet rows.

In this embodiment of the present invention, the photoelectric conversion elements 11 are strip-shaped, the plurality of photoelectric conversion elements 11 are arranged at intervals, and parallel to the eyelet rows.

This embodiment of the present invention further provides a sun shed, which comprises the aforesaid photoelectric conversion eyelet fabric 1; in this way, by using the prevention and utilize of the photoelectric conversion eyelet fabric 1 to light, rainwater, and wind, organisms under the sun shed can be protected more effectively.

The above-described contents are some preferable embodiments of the present invention merely, and are not regarded as being limitation to the present invention, any modifications, equivalent replacements, and improvements made within the principle of the present invention should fall within the protection scope of the present invention.

## Claims

1. A photoelectric conversion eyelet fabric, including a fabric body, wherein the fabric body is provided therein with a plurality of eyelets, which penetrate through the fabric body and are arranged at intervals, one side of the fabric body is provided with a photoelectric conversion element having waterproof facility and electrically connected to an energy storage battery.

2. The photoelectric conversion eyelet fabric according to claim 1, wherein metal wires are arranged on the fabric body, which are grounded in use, deviate from the photoelectric component, and are positioned among the plurality of eyelets.

3. The photoelectric conversion eyelet fabric according to claim 1 or claim 2, wherein the photoelectric conversion element is connected to one side of the fabric body via a collodion silk or other physical ways.

4. The photoelectric conversion eyelet fabric according to claim 2, wherein the plurality of eyelets are distributed on the fabric body in rows and form a plurality of eyelet rows arranged at intervals.

5. The photoelectric conversion eyelet fabric according to claim 4, wherein adjacent ones of the eyelet rows are arranged at intervals.

6. The photoelectric conversion eyelet fabric according to claim 4, wherein the metal wires are positioned between adjacent ones of eyelet rows.

7. A sun shed comprising the photoelectric conversion eyelet fabric according to any of claims 1-6.
